# DEMANDE DE BREVET EUROPEEN

(11) **EP 4 258 324 A1**
(43) Date de publication de la demande: **11.10.2023**
(21) Numéro de dépôt: 23166277.6
(22) Date de dépôt: 03.04.2023
(51) Int. Cl.: H01L 21/20, H01L 23/00, H01L 27/06, H01L 21/78, H01L 21/02

(54) **PROCÉDÉ DE COLLAGE D'UN PREMIER SUBSTRAT AU NIVEAU D'UNE SURFACE PRÉSENTANT UNE NANOTOPOLOGIE ÉLASTIQUE**

(30) Priorité: 04.04.2022 FR 2203033
(71) Demandeur: Commissariat à l'énergie atomique et aux énergies alternatives, 75015 Paris (FR)
(72) Inventeur: FOURNEL, Frank, 38054 GRENOBLE CEDEX 09 (FR); ABADIE, Karine, 38054 GRENOBLE CEDEX 09 (FR)
(74) Mandataire: Cabinet Camus Lebkiri

(57) **Abrégé**

Un aspect de l'invention concerne un procédé de collage d'un premier substrat à un deuxième substrat, le premier substrat comprenant, avant collage, une couche de support, le procédé comprenant : une étape de retrait de la couche de support du premier substrat de sorte à dégager une première surface du premier substrat, ledit retrait entraînant la formation d'une nanotopologie élastique sur la première surface du premier substrat ; une étape de décapage de la première surface avec des atomes de gaz rares ou de dépôt sur la première surface d'un film mince de métal ou de semiconducteur ; une étape de collage par thermocompression du premier substrat contre le deuxième substrat, le contact entre le premier substrat et le deuxième substrat se faisant au niveau de la première surface et d'une deuxième surface du deuxième substrat, cette étape de collage étant réalisée à l'aide d'une technique de collage par diffusion atomique ou d'une technique de collage par activation de surface ; procédé dans lequel l'étape de décapage ou de dépôt et l'étape de collage sont effectuées sous ultravide, la pression étant comprise entre 1 et 100 kN et la température étant comprise entre 200 °C et 600 °C lors de l'étape de collage par thermocompression.

## Description

### DOMAINE TECHNIQUE DE L'INVENTION

Le domaine technique de l'invention est celui du collage de substrats par thermocompression.

La présente invention concerne un procédé de collage par thermocompression et en particulier un procédé de collage par thermocompression d'un substrat ayant une surface présentant une nanotopologie élastique consécutive au retrait d'une couche de support.

### ARRIERE-PLAN TECHNOLOGIQUE DE L'INVENTION

Le collage direct est une technique maintenant bien connue et utilisée pour des applications industrielles comme la fabrication de SOI (Silicon On Insulator en anglais) ou la production d'imageurs par exemple. Le collage direct est un collage spontané entre deux surfaces sans apport de matière, et notamment sans couche épaisse de liquide. Il est néanmoins possible d'avoir quelques monocouches d'eau adsorbées sur les surfaces mais ces dernières sont macroscopiquement sèches. Les surfaces à coller par un procédé de collage direct doivent répondre à des spécifications très strictes. En particulier, elles doivent être très lisses (notamment une rugosité inférieure à 0.5 nm RMS mesurée avec un AFM (pour Atomic Force Microscopy ou microscopie à force atomique en français) sur un scan de 1×1µm²), très planes et, en général, présenter une chimie de surface adaptée

Utiliser la thermocompression pour le collage direct permet en général de relâcher les contraintes en termes de préparation de surface et notamment en termes de rugosité. Néanmoins les inventeurs ont montré que pour certaines nanotopologies de surface induites par des structures sous les surfaces à coller, il n'est pas possible d'utiliser un collage par thermocompression pour obtenir un collage de bonne qualité. En effet, les machines de thermocompression utilisées pour de tels collages arrivent certes à délivrer des pressions uniaxiales de 50 kN à 100 kN sur des plaques de 200 mm de diamètre, mais la répartition de la pression ne permet alors pas de vaincre élastiquement la nanotopologie pour pouvoir coller l'ensemble de la surface. Les surfaces peuvent même se décoller entièrement quand la pression se relâche.

C'est le cas notamment pour les nanotopologies induites par des contraintes internes localisées lors du retrait d'une couche support par exemple le retrait de la couche de silicium en face arrière d'un substrat SOI. Ces nanotopologies sont appelées nanotopologies élastiques dans la suite.

Aussi, pour pallier la présence de ces nanotopologies et permettre un collage sans défaut, la technique la plus courante consiste à déposer une couche de matériau (très souvent de l'oxyde de silicium) et à réaliser une planarisation par un polissage mécano-chimique (ou CMP) de sorte à s'affranchir de cette nanotopologie, ce qui rend le collage direct parfois complexe.

Aussi, il existe un besoin d'un procédé de collage qui permette, pour au moins certaines nanotopologies, de coller deux surfaces sans avoir recours à une étape de planarisation au niveau des surfaces à coller, voire sans avoir recours au dépôt d'une couche de matériau au niveau de la surface à coller.

### RESUME DE L'INVENTION

L'invention offre une solution aux problèmes évoqués précédemment dans le cas de nanotopologie élastique, en permettant un collage sans planarisation, le procédé selon l'invention utilisant la pression lors du thermocollage pour réduire la nanotopologie élastique, le collage étant précédé d'une étape de préparation de surface sous ultra-vide par décapage de la surface avec des atomes de gaz rares ou par un dépôt d'un film mince de métal ou de semi-conducteur.

Ces étapes de préparation sont similaires à celles mises en oeuvre par ailleurs dans un collage SAB - pour Surface Activated Bonding en anglais ou collage par activation de surface en français - et ADB - pour Atomic Diffusion Bonding en anglais ou collage par diffusion atomique en français. Ces collages sont des collages directs covalents consistant à mettre en oeuvre directement au moment du collage direct des liaisons covalentes. Ceci est possible faisant apparaitre sous ultravide (pression <10⁻⁸ mbar soit environ <10⁻⁶ Pa) des liaisons pendantes soit pour le SAB à l'aide d'un décapage de la surface avec des atomes de gaz rares (très souvent de l'argon) ou pour l'ADB par le dépôt d'un film très fin (souvent inférieur à 10 nm) de métal ou de semi-conducteur comme le silicium par exemple. Ces collages sont réalisés à basse température, typiquement inférieure à 200°C voire, principalement, à température ambiante.

Pour cela, un aspect de l'invention concerne un procédé de collage d'un premier substrat à un deuxième substrat, le premier substrat comprenant, avant collage, une couche de support, le procédé comprenant :
- une étape de retrait de la couche de support du premier substrat de sorte à dégager une première surface du premier substrat, ledit retrait entrainant la formation d'une nanotopologie élastique sur la première surface du premier substrat ;
- une étape de décapage de la première surface avec des atomes de gaz rares ou de dépôt sur la première surface d'un film mince de métal ou de semi-conducteur ;
- une étape de collage par thermocompression du premier substrat contre le deuxième substrat, le contact entre le premier substrat et le deuxième substrat se faisant au niveau de la première surface et d'une deuxième surface du deuxième substrat, cette étape de collage étant réalisée à l'aide d'une technique de collage par diffusion atomique (désignée dans la suite par l'acronyme anglais ADB) lorsqu'une étape de dépôt d'un film mince a été mise en oeuvre ou d'une technique de collage par activation de surface (désignée dans la suite par l'acronyme anglais SAB) lorsqu'une étape de décapage a été mise en oeuvre.

De plus, dans le procédé selon l'invention, les étapes de décapage ou de dépôt et de collage par thermocompression sont réalisées sous ultravide (c'est-à-dire à une pression <10⁻⁸ mbar).

En outre, dans le procédé selon l'invention, lors de l'étape de collage par thermocompression, la pression est comprise entre 1 et 100 kN et la température est comprise entre la température ambiante et 600°C voire entre 100°C et 300°C.

On entend par film mince, une couche dont l'épaisseur est inférieure ou égale à 50 nm, de préférence inférieure ou égale à 10nm, voire inférieure ou égale à 2nm et dont l'épaisseur est supérieure ou égal à 0.1 nm, de préférence supérieure ou égal à 0.5 nm. Grâce à l'invention, il est possible de coller une surface présentant une nanotopologie élastique ayant des caractéristiques normalement incompatibles avec un collage direct sans avoir recours à un polissage mécano-chimique, voire sans avoir recours à un dépôt d'une couche de matériau au niveau de la surface à coller, par exemple lorsque la première surface est en silicium (sans oxyde à sa surface) et que la deuxième surface est également en silicium.

Outre les caractéristiques qui viennent d'être évoquées dans le paragraphe précédent, le procédé selon l'invention peut présenter une ou plusieurs caractéristiques complémentaires parmi les suivantes, considérées individuellement ou selon toutes les combinaisons techniquement possibles.

Dans un mode de réalisation, lors de l'étape de collage par thermocompression, la pression est comprise entre 30 kN et 50 kN.

Dans un mode de réalisation, lors de l'étape de collage par thermocompression, la température est comprise entre 100°C et 300 °C.

Dans un mode de réalisation, l'étape de collage est réalisée à l'aide d'une technique de collage par diffusion atomique et le film mince déposé lors de l'étape de dépôt d'un film mince est un film mince de silicium, de germanium, de titane, de tungstène, de nickel ou de cuivre (cette liste n'étant pas exhaustive).

Dans un mode de réalisation, l'étape de collage est effectuée à l'aide d'une technique de collage par activation de surface et l'activation de surface est réalisée à l'aide d'un gaz rare choisi parmi l'argon, d'hélium, de néon ou bien encore de xénon.

L'invention et ses différentes applications seront mieux comprises à la lecture de la description qui suit et à l'examen des figures qui l'accompagnent.

### BREVE DESCRIPTION DES FIGURES

Les figures sont présentées à titre indicatif et nullement limitatif de l'invention.
La [Fig. 1] montre un logigramme d'un procédé selon l'invention.
Les [Fig. 2A], [Fig. 2B] et [Fig. 2C] illustrent les différentes étapes du procédé selon l'invention.

### DESCRIPTION DETAILLEE

Sauf précision contraire, un même élément apparaissant sur des figures différentes présente une référence unique.

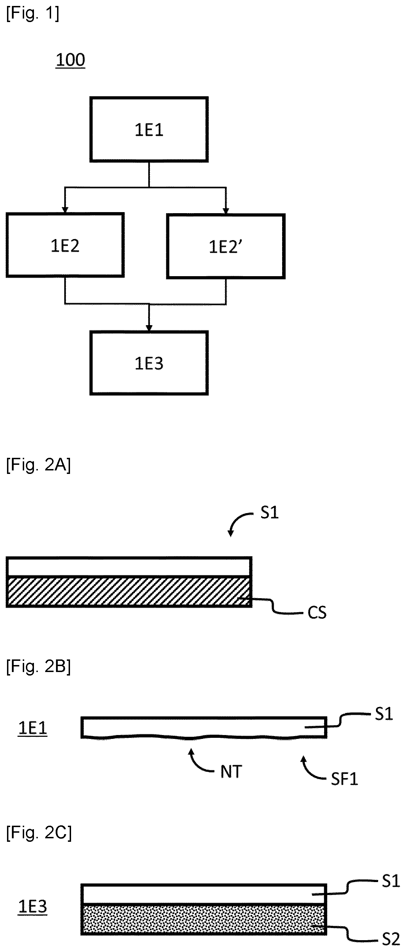

Un aspect de l'invention illustré à la [Fig. 1], aux [Fig. 2A] à [Fig. 2C] concerne un procédé 100 de collage d'un premier substrat S1 à un deuxième substrat S2, le premier substrat S1 comprenant initialement, c'est-à-dire avant collage, une couche de support CS. Une couche de support CS est entendue ici comme une couche (pouvant comprendre une ou plusieurs sous-couches) destinée à être retirée avant l'étape 1E2 de collage par thermocompression et produisant, lors de ce retrait, une nanotopologie élastique NT au niveau d'une surface SF1 du premier substrat, dite première surface SF1 dans la suite.

Dans un mode de réalisation, le premier substrat S1 est une plaque de silicium de type SOI (pour Silicon On Insulator en anglais), sur laquelle ont été réalisés des CMOS ainsi qu'un ou plusieurs niveaux de connexion. Dans ce cas, la couche de support CS est la couche de silicium située sous la couche d'oxyde enterré (ou BOX) du substrat SOI. De la même manière, dans un mode de réalisation, le deuxième substrat S2 est une plaque de silicium, par exemple une plaque de type SOI, sur laquelle ont été réalisés des CMOS ainsi qu'un ou plusieurs niveaux de connexion, et présentant, au niveau de la surface destinée à être collée, une topologie compatible avec un collage direct ou bien encore une topologie élastique telle qu'introduite précédemment.

### Exemple de mise en oeuvre

Dans un exemple de réalisation qui servira dans la suite à illustrer le procédé selon l'invention, le premier substrat S1 est une plaque de silicium de type SOI de 200 mm de diamètre, dont l'oxyde enterré fait environ 400 nm d'épaisseur et sur laquelle sont réalisés des CMOS ainsi qu'un ou plusieurs niveaux (par exemple quatre niveaux) d'interconnexions électriques. Cette plaque de silicium présente, au niveau de la surface sur laquelle ont été réalisés les CMOS, une nanotopologie en surface de 200 nm d'amplitude sur 50 µm de large et avec une période d'environ 2 cm. Il s'agit des futurs chemins de découpe des puces CMOS.

### Retrait de la couche de support

Comme illustré à la [Fig. 2B], le procédé 100 comprend tout d'abord étape 1E1 de retrait de la couche de support CS du premier substrat S1 de sorte à dégager une première surface SF1 du premier substrat S1, ledit retrait entrainant la formation d'une nanotopologie élastique NT sur la surface SF1 considérée. Cette étape 1E1 peut par exemple mise en oeuvre à l'aide d'un substrat intermédiaire, parfois appelé poignée.

La nanotopologie élastique formée lors de cette étape 1E1 est due à des contraintes internes localisées : dans l'exemple de réalisation introduit précédemment et repris dans la suite, cette topologie élastique est induite par la formation des CMOS en face avant (c'est-à-dire la face opposée à la première surface SF1) du premier substrat S1. De manière plus générale, pour qu'une nanotopologie élastique NT selon l'invention apparaisse lors du retrait de la couche de support CS, il suffit que le premier substrat S1 ait subi, alors que la couche de support CS était encore présente, une ou plusieurs étapes de procédé, par exemple une ou plusieurs étapes de procédé CMOS.

### Exemple de mise en oeuvre

Dans l'exemple de réalisation déjà introduit, cette étape 1E1 de retrait est réalisée à l'aide d'un substrat intermédiaire (ici une plaque de silicium) et comprend plusieurs sous-étapes.

Elle comprend d'abord une sous-étape de dépôt d'une couche d'oxyde de silicium, de préférence ayant une épaisseur de 800nm, au niveau de la surface comportant les CMOS, c'est-à-dire la surface opposée à la couche de support CS à retirer.

Elle comprend ensuite une sous-étape de polissage mécano-chimique (ou CMP) de la couche d'oxyde précédemment déposée, par exemple une CMP de 600 nm, cette sous-étape permettant de rattraper les irrégularités de surface induites par la nanotopologie présente sur la surface sur laquelle a été déposée la couche d'oxyde.

Elle comprend ensuite une sous-étape de collage direct du premier substrat S1 sur une plaque de silicium (ou poignée) suivie d'une sous-étape de recuit, par exemple un recuit à 400°C pendant 2h.

Elle comprend également une sous-étape de retrait de la couche de silicium (jouant ici le rôle de couche de support CS) du substrat SOI, cette sous-étape de retrait étant effectuée en trois phases : une phase de meulage (ou grinding en anglais), par exemple jusqu'à 50 µm, une première phase de gravure chimique à base de HF/HNOs pour ne laisser que 5 µm de silicium et enfin une deuxième phase de gravure chimique à l'aide d'une solution à base de TMAH à 12.5 %, à 50 °C pendant quelques minutes afin de retirer le reste de la couche de silicium (ou couche support CS) en arrêtant la gravure sur la face arrière de l'oxyde enterrée du SOI, exposant ici la première surface SF1 selon l'invention.

Le TMAH permet d'avoir une surface d'oxyde avec une rugosité mesurée par AFM sur un scan de 1×1 µm² inférieure à 0.5 nm RMS, c'est-à-dire une surface compatible avec un collage direct. Cependant, à cause du retrait de la couche de support CS en silicium, une nanotopologie élastique pouvant aller jusqu'à quelques dizaines de nanomètres apparait en face arrière, c'est-à-dire au niveau de la première surface SF1 selon l'invention, rendant un collage direct sans CMP au niveau de cette surface SF1 impossible.

### Décapage ou dépôt d'un film mince

Le procédé selon l'invention comprend ensuite une étape 1E2 de décapage de la première surface SF1 avec des atomes de gaz rares ou de dépôt sur la première surface SF1 d'un film mince.

### Exemple de mise en oeuvre

Dans le cadre de l'exemple de mise en oeuvre utilisé jusqu'à présent, cette étape 1E2 de décapage ou de dépôt peut être mise en oeuvre selon au moins deux modes différents.

### Premier mode de mise en oeuvre

Dans un premier mode de mise en oeuvre, lors de cette étape 1E2, une fine couche, par exemple une épaisseur comprise entre 5 et 10 nm, de silicium amorphe est déposée sur la première surface SF1 à 400°C. De préférence, cette étape est suivie d'un recuit de dégazage réalisé à 450°C pendant une heure.

Ensuite, le décapage de la première surface SF1 est mis en oeuvre sous ultra vide afin d'exposer la couche de silicium en retirant son oxyde natif.

### Deuxième mode de mise en oeuvre

Dans un deuxième mode de mise en oeuvre, lors de cette étape 1E2, une couche de silicium de 10 nm d'épaisseur est déposée sous ultravide sur la première surface SF1.

### Collage par thermocompression

Comme illustré à la [Fig. 2C], le procédé 100 selon l'invention comprend ensuite une étape 1E3 de collage par thermocompression du premier substrat S1 sur le deuxième substrat S2, le contact entre le premier substrat S1 et le deuxième substrat S2 se faisant au niveau de la première surface SF1 du premier substrat S1 et d'une deuxième surface du deuxième substrat S2. De plus, lors de cette étape 1E3 de collage par thermocompression, la pression appliquée est comprise entre 1 et 100 kN, de préférence comprise entre 30 kN et 50 kN, et la température est comprise entre la température ambiante et 600 °C, de préférence comprise entre 100 °C et 300 °C.

Dans un mode de réalisation, l'étape de collage par thermocompression est réalisée à l'aide d'une technique de collage SAB. De préférence, l'activation de la surface de la technologie SAB est réalisée à l'aide d'un gaz rare, de préférence choisi parmi l'argon, d'hélium, de néon ou bien encore de xénon.

Dans un mode de réalisation alternatif, l'étape de collage par thermocompression est réalisée à l'aide d'une technique de collage ADB, à l'aide d'une couche de silicium ou bien encore une couche de métal tel que le tungstène (W) ou le titane (Ti).

### Exemple de mise en oeuvre

Dans le cadre de l'exemple de mise en oeuvre utilisé jusqu'à présent, cette étape 1 E3 de collage par thermocompression peut être mise en oeuvre selon au moins deux modes différents.

### Premier mode de mise en oeuvre

Dans le premier mode de mise en oeuvre déjà introduit, l'étape 1E3 de collage est réalisée à l'aide d'une technique de collage par activation de surface SAB sur une plaque de silicium (ou une plaque ayant subi une ou plusieurs étapes de procédé de fabrication qui présente une couche collable par collage direct en surface et compatible avec la technologie SAB) jouant le rôle de second substrat S2 selon l'invention. Plus particulièrement, dans cet exemple de réalisation, après l'étape 1E2 de dépôt d'une couche mince de silicium, le procédé comprend, une étape 1E3 de collage avec une activation de la première surface SF1 et de la deuxième surface SF2 par un faisceau d'argon de 200 eV, 150 mA suivie du collage proprement dit réalisé en appliquant une pression de 50 kN et une température de 300°C tout en restant sous ultra-vide. La structure obtenue à l'issue du procédé selon l'invention ne présente pas les défauts de collage qu'aurait dû engendrer la nanotopologie élastique présente au niveau de la première surface SF1 du premier substrat S1.

### Deuxième mode de mise en oeuvre

Dans le deuxième mode de mise en oeuvre déjà introduit, l'étape 1E3 de collage par thermocompression est réalisée par une méthode ADB sur une plaque de silicium (ou une plaque ayant subi une ou plusieurs étapes de procédé de fabrication qui présente une couche collable par collage direct en surface et compatible avec la technologie ADB) jouant le rôle de second substrat S2 selon l'invention. Plus particulièrement, dans cet exemple de réalisation, à l'issue de l'étape 1E2 de dépôt sur la première surface SF1 d'une couche de silicium de 10 nm d'épaisseur réalisée elle-même sous ultra vide décrite précédemment, le procédé comprend, en maintenant l'ultravide, une étape 1E3 de collage par une mise en contact des substrats S1, S2 en appliquant une pression de 50 kN et une température de 300 °C. Comme pour le premier mode de mise en oeuvre, la structure obtenue à l'issue du procédé 100 selon l'invention ne présente pas les défauts de collage qu'aurait dû engendrer la nanotopologie élastique présente au niveau de la première surface SF1 du premier substrat S1.

Comme cela vient d'être détaillé, le procédé 100 selon l'invention permet de coller une surface SF1 présentant une topologie normalement incompatible avec un collage direct lorsque cette topologie est une topologie élastique. De plus, ce collage peut être effectué sans avoir recours à un polissage mécano-chimique, voire sans avoir recours à un dépôt d'une couche de matériau au niveau de la surface à coller.

## Revendications

1. Procédé (100) de collage d'un premier substrat (S1) à un deuxième substrat (S2), le premier substrat (S1) comprenant, avant collage, une couche de support (CS), le procédé (100) comprenant :
- une étape (1E1) de retrait de la couche de support (CS) du premier substrat (S1) de sorte à dégager une première surface (SF1) du premier substrat (S1), ledit retrait entrainant la formation d'une nanotopologie élastique (NT) sur la première surface (SF1) du premier substrat (S1) ;
- une étape (1E2, 1E2') de décapage de la première surface avec des atomes de gaz rares ou de dépôt sur la première surface d'un film mince de métal ou de semi-conducteur ;
- une étape (1E3) de collage par thermocompression du premier substrat (S1) contre le deuxième substrat (S2), le contact entre le premier substrat (S1) et le deuxième substrat (S2) se faisant au niveau de la première surface (SF1) et d'une deuxième surface du deuxième substrat (S2), cette étape de collage étant réalisée à l'aide d'une technique de collage par diffusion atomique (ADB) lorsqu'une étape de dépôt d'un film mince a été mise en oeuvre ou d'une technique de collage par activation de surface (SAB) lorsqu'une étape de décapage a été mise en oeuvre ;
procédé (100) dans lequel l'étape (1E2,1E2') de décapage ou de dépôt et l'étape (1E3) de collage sont effectuées sous ultravide, la pression étant comprise entre 1 et 100 kN et la température étant comprise entre la température ambiante et 600 °C lors de l'étape (1E3) de collage par thermocompression.

2. Procédé selon la revendication précédente dans lequel, lors de l'étape de collage par thermocompression, la pression est comprise entre 30 kN et 50 kN.

3. Procédé selon l'une des revendications précédentes dans lequel, lors de l'étape de collage par thermocompression, la température est comprise entre 100 °C et 300 °C.

4. Procédé selon l'une des revendications précédentes dans lequel, l'étape de collage est réalisée à l'aide d'une technique de collage par activation de surface et l'activation de surface est réalisée à l'aide d'un gaz rare choisi parmi l'argon, d'hélium, de néon ou bien encore de xénon.

5. Procédé selon l'une des revendications 1 à 3 dans lequel l'étape de collage par thermocompression est réalisée à l'aide d'une technique de collage par diffusion atomique et dans lequel le film mince déposé lors de l'étape de dépôt d'un film mince est un film mince de silicium, de germanium, de titane, de tungstène, de nickel ou de cuivre.
